# DEMANDE DE BREVET EUROPEEN

(11) **EP 1 619 726 A1**
(43) Date de publication de la demande: **25.01.2006**
(21) Numéro de dépôt: 05106672.8
(22) Date de dépôt: 20.07.2005
(51) Int. Cl.: H01L 31/0203, H01L 31/0232

(54) **Boîtier optique pour capteur semiconducteur**

(30) Priorité: 22.07.2004 FR 0451618
(71) Demandeur: ST MICROELECTRONICS S.A., 92120 Montrouge (FR)
(72) Inventeur: Vigier-Blanc, Emmanuelle, 38700, Le Sappey en Chartreuse (FR)
(74) Mandataire: de Beaumont, Michel

(57) **Abrégé**

L'invention concerne un boîtier optique (10') pour puces (1) de circuit intégré comprenant des microcapteurs optiques et son procédé de fabrication, une épaisseur de résine d'encapsulation plus fine que l'épaisseur prévue au droit de fils de report de contact (22) étant prévue au moins à l'aplomb des microcapteurs entre la surface supérieure de la puce et un substrat (2) la portant.

## Description

### Domaine de l'invention

La présente invention concerne de façon générale les capteurs optiques réalisés par des circuits intégrés utilisant la technologie des semiconducteurs. De tels capteurs sont constitués essentiellement d'un réseau de phototransistors et réalisés dans une puce de circuit intégré, montée sur un substrat pour une mise en boîtier avec une lentille de focalisation.

L'invention concerne plus particulièrement les dispositifs semiconducteurs à capteur optique dont la lentille de focalisation permet d'éviter un réglage de distance focale (focus).

La présente invention s'applique plus particulièrement aux capteurs optiques destinés à réaliser des microcaméras ou des souris optiques.

### Exposé de l'art antérieur

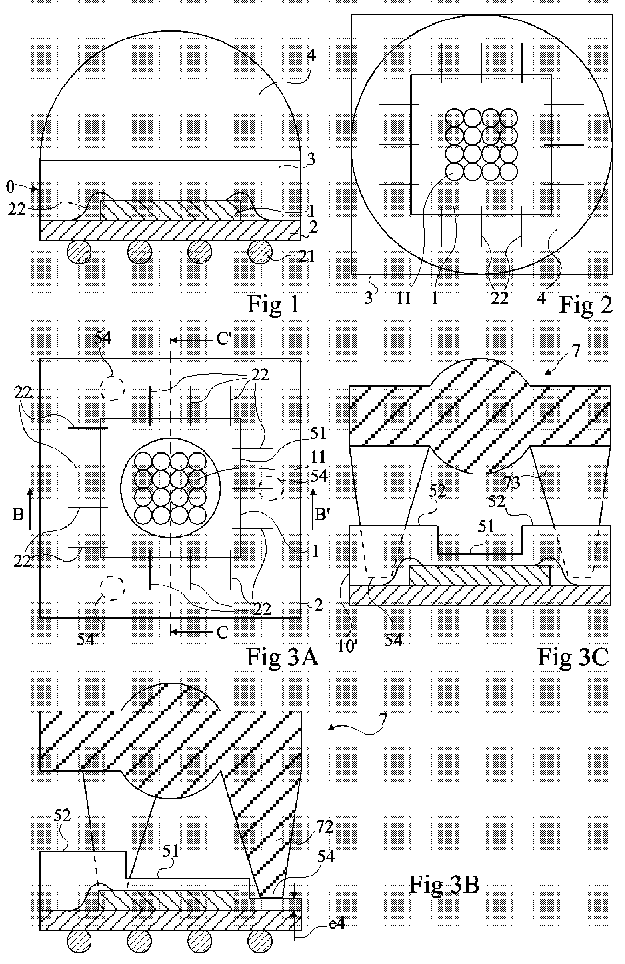

Les figures 1 et 2 représentent, respectivement par une vue en coupe transversale et par une vue de dessus schématique, un exemple classique de boîtier optique 10 à capteurs semiconducteurs. Une puce 1 de circuit intégré dans laquelle ont été réalisés des phototransistors surmontés de microlentilles en silicium est rapportée sur un substrat 2 dans lequel sont réalisés des vias (non représentés) de report de contacts entre sa face avant et sa face arrière. La face arrière du substrat 2 (opposée à celle portant la puce 1) comporte des bossages conducteurs à la manière d'un boîtier BGA (Ball Grid Array). En face avant du substrat 2, sont rapportés des fils conducteurs 22 de reprise de contact depuis la face avant de la puce 1. L'ensemble est encapsulé dans une résine optique 3, surmoulée depuis la face avant du substrat 2. Cette résine est classiquement une résine dite dure pour être compatible avec les qualités optiques recherchées. Une fois la résine solidifiée, une lentille de convergence 4 (généralement hémisphérique) est rapportée sur la face supérieure du boîtier réalisé. Le cas échéant, un diaphragme (non représenté) est intercalé entre le boîtier 10 et la lentille 4.

En figure 2, on a représenté symboliquement le réseau de microcapteurs de la puce de circuit intégré 1 par des cercles 11. En pratique, le nombre de microcapteurs est nettement plus important que le nombre représenté, la puce de circuit intégré étant d'une surface de quelques millimètres carrés, le nombre de phototransistors est, par exemple, de l'ordre de 100 000 pour un capteur de type CIF.

Le choix d'une résine 3 dure est lié d'une part aux caractéristiques optiques de ces résines, et d'autre part au fait que le surmoulage réalisé permet d'obtenir un état de surface suffisamment plan (avec des écarts inférieurs à une quarantaine de micromètres) pour rapporter une lentille convergente 4 en verre.

L'inconvénient majeur d'un surmoulage par une résine dure est que cela engendre des contraintes sur les fils 22 de reprise de contact et engendre un risque de faux contacts.

Un autre inconvénient d'un tel dispositif est qu'il est limité en distance focale. En particulier, il ne permet pas l'adjonction d'une lentille sur pieds à partir de la surface supérieure de la résine 3, à cause des tolérances cumulées des différents matériaux rapportés qui sont incompatibles avec une absence de réglage (focus) de la distance focale.

### Résumé de l'invention

La présente invention vise à proposer une technique d'encapsulation de circuits intégrés comprenant des microcapteurs optiques qui pallie les inconvénients des montages en boîtier connus. En particulier, l'invention vise à permettre le montage de différents types de lentilles sur le boîtier.

L'invention vise également à proposer une solution compatible avec l'utilisation de lentilles à pieds afin d'augmenter la distance focale.

L'invention vise également à proposer une solution compatible avec une soudure à la vague.

L'invention vise en outre à proposer une solution qui ne requiert aucune modification de la réalisation des circuits intégrés de microcapteurs eux-mêmes.

Pour atteindre ces objets ainsi que d'autres, la présente invention prévoit un boîtier optique pour puces de circuit intégré comprenant des microcapteurs optiques, caractérisé en ce qu'il comporte au moins à l'aplomb des microcapteurs, une épaisseur de résine d'encapsulation plus fine que l'épaisseur prévue au droit de fils de report de contact entre la surface supérieure de la puce et un substrat la portant.

Selon un mode de réalisation de la présente invention, une épaisseur de résine relativement fine par rapport à l'épaisseur au droit des fils de reprise de contact est prévue dans des zones de réception de pieds d'une lentille de focalisation.

Selon un mode de réalisation de la présente invention, l'épaisseur réduite au droit des microcapteurs est inférieure à 200 µm, de préférence inférieure à 150 µm.

Selon un mode de réalisation de la présente invention, l'épaisseur de la résine au droit des fils de contact est d'au moins 500 µm.

Selon un mode de réalisation de la présente invention, la résine est une résine thixotrope.

La présente invention prévoit également un procédé de réalisation d'un boîtier optique pour une puce de circuit intégré dans laquelle ont été formés des microcapteurs optiques et qui est rapporté sur un substrat, des fils de report de contact étant soudés entre la face supérieure de la puce et la face du substrat sur laquelle elle repose, consistant à effectuer un dépôt de résine thixotrope par réplication, l'épaisseur de la résine au droit des microcapteurs optiques étant inférieure à l'épaisseur de cette résine au droit des fils de contact.

Selon un mode de mise en oeuvre de la présente invention, une épaisseur moindre de résine par rapport à l'épaisseur au droit des fils de contact est également prévue dans des zones de réception d'une lentille à pieds.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ;
les figures 3A, 3B et 3C représentent respectivement par une vue schématique de dessus et par des vues en coupe selon les lignes B-B' et C-C' de la figure 3A, un mode de réalisation préféré d'un boîtier optique selon la présente invention ;
les figures 4A, 4B, 4C, 4D et 4E illustrent par des vues en coupe schématiques un mode de mise en oeuvre du procédé de réalisation de boîtier optique selon la présente invention ;
la figure 5 est une vue en coupe schématique d'une première variante d'un dispositif optique selon l'invention ; et
la figure 6 est une vue en coupe d'une deuxième variante d'un tel dispositif optique.

### Description détaillée

Par souci de clarté, de mêmes éléments ont été désignés par de mêmes références aux différentes figures et, comme cela est habituel dans la représentation des circuits intégrés, les diverses figures ne sont pas tracées à l'échelle. De plus, seuls les éléments et étapes utiles à la compréhension de l'invention ont été représentés aux figures et seront décrits par la suite. En particulier, la réalisation de la puce de circuit intégré portant les phototransistors formant le réseau de microcapteurs n'a pas été détaillée, l'invention étant compatible avec tout réseau de microcapteurs classiques. De plus, la réalisation des lentilles de focalisation utilisées par l'invention n'a pas non plus été détaillée, l'invention étant compatible avec des lentilles réalisées de façon classique.

Une caractéristique de la présente invention est d'effectuer un dépôt de résine dite de réplication sur le circuit intégré portant les microcapteurs reposant sur un substrat.

Les résines déposées par réplication sont habituellement utilisées dans des techniques de réalisation de disques compacts (Compact Disk ou Digital Vidéo Disk (DVD)) car elles permettent de réaliser des motifs précis dans les trois dimensions X, Y, Z, et notamment en hauteur (ou épaisseur) même sur de grandes surfaces (grandes dimensions en X, Y).

Brièvement, on utilise une résine thixotrope qui devient fluide lorsqu'on y applique une légère pression au moyen d'un moule portant les motifs à former. Ce moule est transparent aux ultraviolets qui servent à pré-polymériser la résine à travers le moule avant qu'elle soit durcie définitivement par un passage au four. Jusqu'à présent, de telles résines déposées par réplication ne sont pas utilisées dans les capteurs électroniques (à puce semiconductrice) en raison de l'épaisseur requise de surmoulage (typiquement supérieure à 500 µm) à cause notamment des fils de report de contact (22, figures 1 et 2). Avec de telles épaisseurs, ces résines perdent leur qualité de faible tolérance dans le motif réalisé (notamment, dans l'épaisseur de la résine) en raison de défauts de surface appelés "retassures" qui apparaissent pour une épaisseur supérieure à environ 200 µm.

Selon la présente invention, ce dépôt de résine par réplication est utilisé avec un motif de moule particulier tel que l'épaisseur de résine rapportée sur la partie centrale du substrat (à l'aplomb des microcapteurs de la puce de circuit intégré) est compatible avec l'absence de retassure dans la résine. A l'extérieur de cette zone, et plus particulièrement au droit des fils de reprise de contact, le moule autorise un dépôt supérieur à 500 µm, donc des retassures. Toutefois, à cet endroit, de tels défauts optiques ne sont pas gênants.

Il s'agit là d'une différence importante par rapport à l'application classique des résines par réplication dans les technologies de CD et de DVD où l'absence de retassure doit être maintenue dans toute la surface du disque optique.

Ainsi, l'invention tire profit des caractéristiques différentes susceptibles d'être recherchées dans la surface du capteur optique pour autoriser la présence ou l'absence de retassures selon les endroits.

Selon un mode de réalisation préféré, une fine épaisseur est également prévue dans des zones de réception de pieds de lentilles de focalisation afin d'autoriser l'emploi de lentilles à pied sans focus. En effet, compte tenu de la faible tolérance (inférieure à 10 µm) des défauts de surface en faible épaisseur de la résine de réplication, on obtient pour le dispositif complet (en tenant compte des tolérances de l'ordre de 10 ou 20 µm au droit des pieds de la lentille de focalisation) un dispositif optique ayant une tolérance de distance focale inférieure à 40 µm. Pour une distance focale de quelques millimètres, de telles tolérances sont compatibles avec la précision recherchée.

Les figures 3A, 3B et 3C représentent un dispositif optique selon un mode de réalisation de la présente invention. La figure 3A est une vue de dessus schématique. La figure 3B est une vue en coupe selon la ligne B-B' de la figure 3A. La figure 3C est une vue en coupe selon la ligne C-C' de la figure 3A.

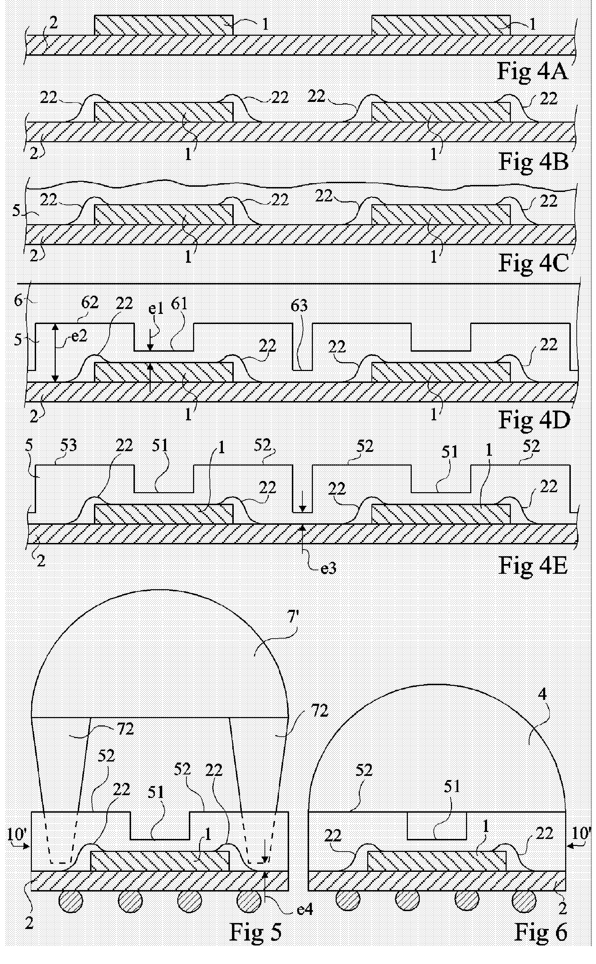

Les figures 3A, 3B et 3C seront décrites en relation avec les figures 4A à 4E qui illustrent un mode de mise en oeuvre du procédé de formation d'un boîtier optique selon l'invention.

Comme précédemment (figure 4A), on part d'un substrat 2 sur lequel sont rapportées des puces 1 de circuit intégré comprenant les microcapteurs (11, figure 3A).

On procède alors (figure 4B) au report des contacts de la face supérieure de la puce 1 vers la face avant du substrat 2 au moyen de fils conducteurs 22.

Selon la présente invention, on dépose ensuite (figure 4C) une couche de résine thixotrope 5 de type résine souple par rapport aux résines dures utilisées habituellement pour encapsuler les circuits intégrés.

La résine 5 est choisie pour avoir des caractéristiques optiques adaptées au dispositif à réaliser. Ceci fait partie de mises au point classiques de ces résines, notamment pour modifier leurs indices optiques.

On rapporte ensuite un moule 6 sur la plaquette portant les circuits 1. Ce moule comporte, dans sa face en regard des plaquettes, des motifs en creux 62 et en saillie 61 et 63 tels qu'au moins l'épaisseur e1 de résine subsistant au droit de la zone des microcapteurs est inférieure à 200 µm (de préférence, inférieure à 150 µm). En figure 4D, le moule 6 a été représenté dans sa position définitive. On notera toutefois que celui-ci est rapporté avec un alignement correct dans le plan. La légère pression appliquée sur ce moule (par rapport à la pression nécessaire avec les résines dures classiques) fluidifie la résine 5 de sorte qu'elle remplit aisément les contre-formes du moule 6, sans imposer de contraintes dommageables aux fils 22. On soumet alors l'ensemble aux ultraviolets de façon à prépolymériser (prédurcir) la résine. Selon l'invention, l'épaisseur e2 de résine au droit des fils de report de contact est d'au moins 500 µm.

Une fois la résine prépolymérisée, le moule 6 est ôté et l'ensemble est passé dans un four pour durcir la résine. On obtient alors la structure collective représentée en figure 4E dans laquelle la couche de résine formant le boîtier optique 10' présente des différences d'épaisseur selon les zones. En particulier, les zones 51 au droit des microcapteurs sont de faible épaisseur par rapport aux zones 52 au droit des fils 22.

De préférence, une faible épaisseur de résine est également prévue aux endroits des chemins de découpe. Cette épaisseur e3 conditionnée par des motifs 63 en saillie du moule 6 est par exemple d'environ 200 µm.

Dans le mode de réalisation préféré des figures 3, une faible épaisseur e4 de résine est également prévue dans des zones 54 (figures 3A et 3B) de réception de pieds 72 (figures 3B et 3C) d'une lentille à pieds. Cette faible épaisseur permet de respecter les tolérances en hauteur de positionnement de la lentille à pieds pour accroître la distance focale des dispositifs optiques.

Dans l'exemple des figures 3, il s'agit d'une lentille à BFL (Back Focal Lens) réduit dont la distance focale est fixée par la distance entre le point focal et l'un des points d'appui physique.

On notera que le fait que la faible épaisseur e1 de résine soit en creux par rapport au pourtour relativement épais en périphérie permet de protéger cette zone du capteur optique pendant la manipulation de la plaquette (figure 4E) avant sa découpe.

L'assemblage final de la lentille de focalisation s'effectue par collage des pieds de celle-ci sur les zones de réception prévues. Ensuite, l'ensemble est directement monté sur un circuit imprimé de réception lié à l'application.

Un avantage de la présente invention est qu'elle permet d'éviter les risques de casse des fils de report de contact lors de l'encapsulation de la structure optique.

Un autre avantage de l'invention est qu'elle permet l'utilisation de lentille à pieds, donc d'augmenter la distance focale.

Un autre avantage de l'invention est qu'elle permet une soudure à la vague des circuits ainsi réalisés.

La figure 5 représente une première variante dans laquelle une lentille à pieds est une lentille hémisphérique 7'. On utilise alors la même méthode de prévoir des épaisseurs faibles e4 de résine au droit des pieds 72 de la lentille. De préférence, le nombre de pieds de lentille à pieds est 3.

La figure 6 représente une deuxième variante simplifiée de l'invention. Dans cette variante, on rapporte une lentille hémisphérique 4 directement sur le boîtier optique 10' issu de la mise en oeuvre de l'invention. Par rapport à la réalisation classique de la figure 1, les avantages qui subsistent dans ce mode de réalisation, sont l'utilisation d'une résine déposée par réplication ce qui limite les contraintes appliquées aux fils lors du surmoulage. Par contre, cela ne permet pas d'accroître la distance focale comme avec une lentille à pieds.

Bien entendu, la présente invention est susceptible de diverses variantes et modifications qui apparaîtront à l'homme de l'art. En particulier, le choix de la résine à utiliser est à la portée de l'homme du métier en fonction de l'application.

## Revendications

1. Boîtier optique (10') pour puces (1) de circuit intégré comprenant des microcapteurs optiques, **caractérisé en ce qu'**il comporte au moins à l'aplomb des microcapteurs, une épaisseur (e1) de résine d'encapsulation plus fine que l'épaisseur (e2) prévue au droit de fils (22) de report de contact entre la surface supérieure de la puce et un substrat (2) la portant.

2. Boîtier selon la revendication 1, dans lequel une épaisseur (e4) de résine relativement fine par rapport à l'épaisseur (e1) au droit des fils (22) de reprise de contact est prévue dans des zones (54) de réception de pieds (72) d'une lentille de focalisation (7, 7').

3. Boîtier selon la revendication 1 ou 2, dans lequel l'épaisseur (e1) réduite au droit des microcapteurs est inférieure à 200 µm, de préférence inférieure à 150 µm.

4. Boîtier selon l'une quelconque des revendications 1 à 3, dans lequel l'épaisseur (e2) de la résine au droit des fils de contact (22) est d'au moins 500 µm.

5. Boîtier selon l'une quelconque des revendications 1 à 4, dans lequel la résine est une résine thixotrope.

6. Procédé de réalisation d'un boîtier optique (10') pour une puce (1) de circuit intégré dans laquelle ont été formés des microcapteurs optiques et qui est rapporté sur un substrat (2), des fils (22) de report de contact étant soudés entre la face supérieure de la puce et la face du substrat sur laquelle elle repose, **caractérisé en ce qu'**il consiste à effectuer un dépôt de résine thixotrope par réplication, l'épaisseur (e1) de la résine au droit des microcapteurs optiques étant inférieure à l'épaisseur (e2) de cette résine au droit des fils de contact.

7. Procédé selon la revendication 6, dans lequel une épaisseur (e4) moindre de résine par rapport à l'épaisseur au droit des fils (22) de contact est également prévue dans des zones (54) de réception d'une lentille à pieds (7, 7').
